(19) Europäisches Patentamt / European Patent Office / Office européen des brevets

(11) **EP 2 397 956 B1**

(12) **EUROPEAN PATENT SPECIFICATION**

(45) Date of publication and mention
of the grant of the patent:
**26.08.2015 Bulletin 2015/35**

(51) Int Cl.:
***G06F 17/50*** (2006.01)

(21) Application number: **11002881.8**

(22) Date of filing: **06.04.2011**

(54) **Method for simulating article made of viscoelastic material**

Verfahren zur Simulation eines Artikels aus einem viskoelastischen Material

Procédé de simulation d'article fabriqué à partir de matériau viscoélastique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.06.2010 JP 2010140838**

(43) Date of publication of application:
**21.12.2011 Bulletin 2011/51**

(73) Proprietor: **Sumitomo Rubber Industries, Ltd.**
**Hyogo-ken (JP)**

(72) Inventors:
• **Tamada, Ryota**
**Kobe-shi**
**Hyogo 651-0072 (JP)**
• **Tsunoda, Masaya**
**Kobe-shi**
**Hyogo 651-0072 (JP)**

(74) Representative: **Manitz, Finsterwald & Partner GbR**
**Postfach 31 02 20**
**80102 München (DE)**

(56) References cited:
**US-B2- 7 130 748**

• **K TANAKA ET AL: "Construction of the Finite-Element Models of Golf Balls and Simulations of Their Collisions", PROCEEDINGS OF THE INSTITUTION OF MECHANICAL ENGINEERS, PART L: JOURNAL OF MATERIALS: DESIGN AND APPLICATIONS, vol. 220, no. 1, 1 June 2006 (2006-06-01), pages 13-22, XP055093822, ISSN: 1464-4207, DOI: 10.1243/14644207JMDA80**

**Description**

**Background of the invention**

The present invention relates to a method for computer simulation of an article made of a viscoelastic material, wherein when the article model is deformed, the viscoelastic property already defined for elements constituting an article model are renewed correspondingly to the strain amounts obtained when the article model is deformed.

In recent years, in order to save time and cost for developing various articles made of viscoelastic materials as typified by high-polymer materials such as rubber and elastomer (for example, vehicle tires, balls used in sports, rollers used in printing machines, etc.), computerized deformation simulations have become widely employed to evaluate various performances and/or characteristics, for example, dynamic performances of a tire during running, rebound characteristics of a golf ball at impact and the like.

In the computerized deformation simulations, the article as an analysis object is modeled by a finite number of elements to define an article model, and values of a viscoelastic property are defined for the elements correspondingly to the materials represented by the elements, then deformation simulation or deformation calculation is carried out on the article model under specified conditions.

In general, when a viscoelastic material is deformed and the strain amount of the viscoelastic material is changed, then values of a viscoelastic property thereof also makes a change, which means that the viscoelastic property has dependency on strain amount as well as dependency on strain rate.

In the heretofore known simulation algorithms, however, such strain amount dependencies are not taken into consideration. In other words, the elements of the article model are provided with fixed values of the viscoelastic property determined at a given strain amount. Accordingly, the heretofore known simulation algorithms have their own limits in the betterment of simulation accuracy.

US 7 130 748 B2 discloses a simulation method for estimating the performance of a product made of a viscoelastic material, in which:

- an article model of the article made with a finite number of elements is defined,
- a value of a viscoelastic property for each of the elements of the article model is defined,
- a deformation simulation of the article model is made,
- a strain amount of each of the elements from the deformation simulation is obtained,
- the values of the viscoelastic property according to the obtained strain amounts are renewed so as to redefine the article model, and
- a deformation result of the deformation simulation is output.

Further prior art is known from a scientific publication by K. Tanaka et al.: "Construction of the Finite-Element Models of Golf Balls and Simulations of Their Collisions", Proceedings of the Institution of Mechanical Engineers, Part L: Journal of Materials Design and Applications, Vol. 220, No. 1, 1 June 2006, pages 13-22, XP055093822.

summary of the Invention

It is therefore, a primary object of the present invention to provide a method for simulating an article made of a viscoelastic material by which the article is simulated with accuracy and thereby it is possible to accurately estimate performances and/or properties of the article.

The object is satisfied by a method in accordance with the features of claim 1. Preferred embodiments of the present invention are described in the dependent claims.

In this invention, the term "article" means every thing having a definite shape as the analysis object. In particular, finished products supplied to the users (for example, golf ball, rubber roller, tire, etc.) as well as unfinished products including their component parts (for example, a core of a golf ball and the like) are included.

The article is made of one or more kinds of viscoelastic materials.

The term "viscoelastic material" means every material having viscosity and elasticity. For example, thermoplastic resins, thermo-setting resins, various elastomers, rubber and the like are included.

The viscoelastic property include at least the relation between stress $\sigma$ and strain $\varepsilon$ of the viscoelastic material.

The values of the viscoelastic property can be determined from measurement of the viscoelastic material, using various test procedures, for example, creep test, dynamic viscoelastic property test, split Hopkinson bar test, relaxation test, ultrasonic test and the like.

The object of the invention is solved by a method for computerized simulation of an article made of a viscoelastic material as defined in claim 1.

Therefore, the strain amount dependency of the viscoelastic material is reflected in deformation calculation of each of the elements of the article model, and highly accurate simulations become possible.

Brief Description of the Drawings

Fig.1 shows an example of the computer for executing a simulation method according to the present invention.
Fig.2 is a flowchart showing a procedure of the simulation method.
Fig.3 shows one half of an article model (golf ball model).
Fig.4 is a graph showing a viscoelastic property (relation between stress $\sigma$ and strain $\varepsilon$) having strain amount dependency.
Fig.5(a) and Fig.5(b) are cross sectional views showing an example of the deformation simulation.
Fig.6 shows the article model of which elements are classified by their strain amounts into groups G1-G5.
Fig.7 shows the elements belonging to group G1.
Fig.8 shows the elements belonging to group G2.
Fig.9 shows the elements belonging to group G3.
Fig.10 shows the elements belonging to group G4.
Fig.11 shows the elements belonging to group G5.
Fig.12 shows a ball-hitting simulation.
Figs.13-19 are graphs each showing correlations between simulation results and actual test results.

Description of the Preferred Embodiments

Embodiments of present invention will now be described in detail in conjunction with accompanying drawings.

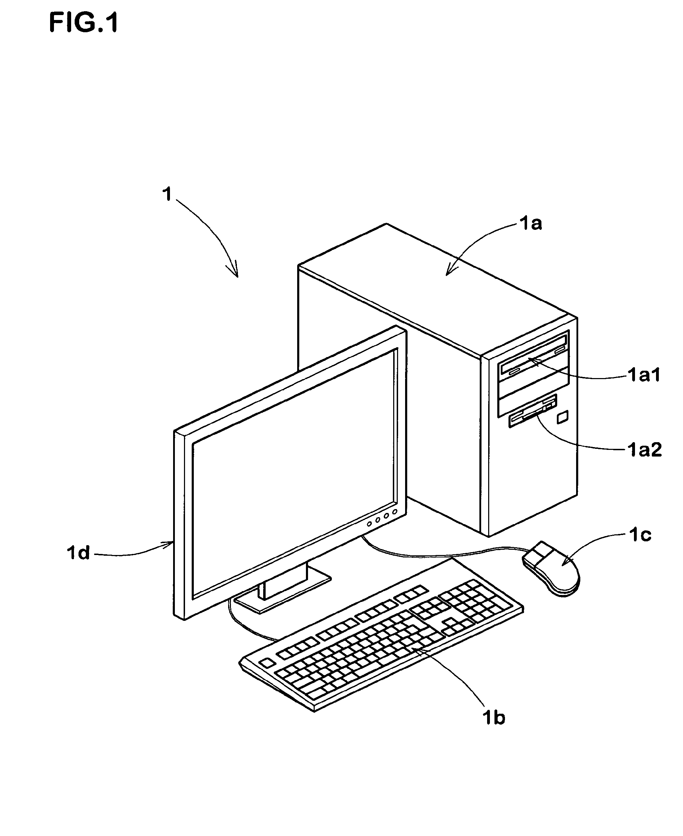

Fig.1 shows a computer 1 for executing a simulation method according to the present invention. The computer 1 in this example comprises main units 1a, input devices, e.g. a keyboard 1b, mouse 1c and the like, output devices, e.g. a display 1d, printer and the like. The main units 1a comprises a central processing unit (CPU), memories, a magnetic disk, a compact-disc unit 1a1, a flexible disk unit 1a2 and the like. In the magnetic disk, programs for carrying out the simulation method according to the present invention are stored.

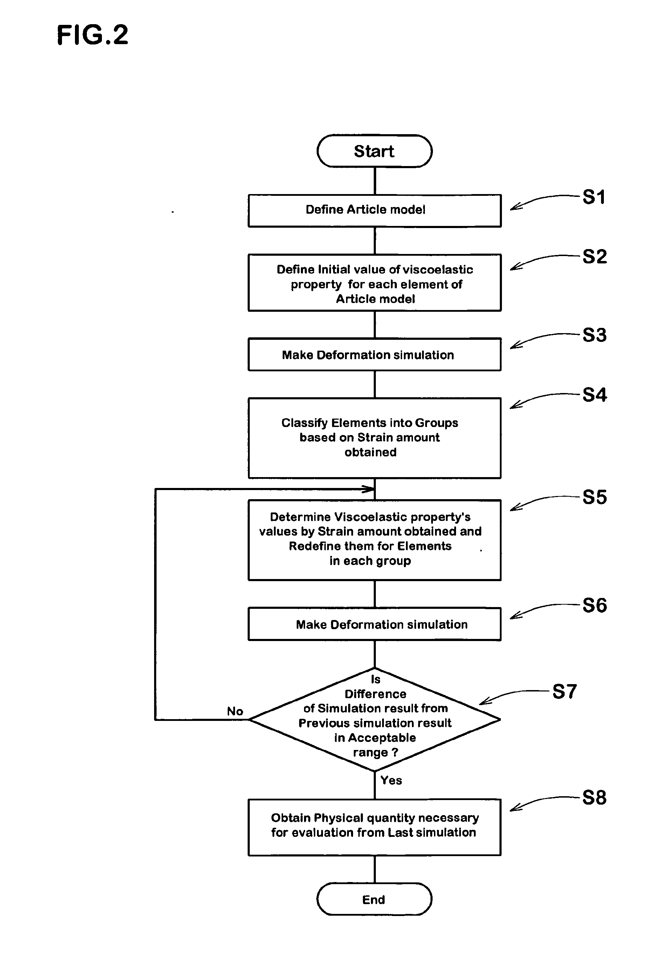

Fig.2 shows an example of the flowchart of the procedure of a simulation method according to the present invention. This simulation method comprises the following steps S1-S8.

<Step S1>

First, an article model is defined. The article model is a model of an article modeled by a finite number of elements (e) so that numerical analysis method, e.g. for example finite element method and the like can be used to make calculations.

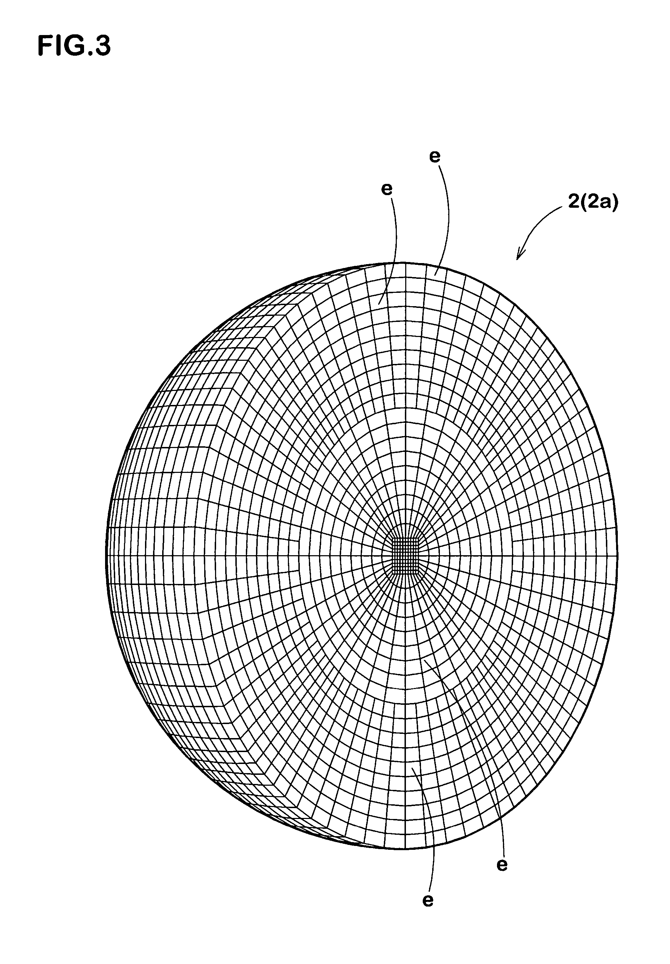

Fig.3 shows a visualization of the article model 2 in perspective. In this example, the article model 2 is a three-dimensional model 2a of a golf ball made with Lagrange elements of which unknown quantities are displacement.

In order to reduce the computational cost, it is possible to reduce the number of the elements by utilizing a geometrical symmetry of the article. In the case of Fig.3, the golf ball model 2a is modeled as a hemispheroid.

The article model 2 is entered and stored in the computer 1. More specifically, numerical data on indexes of the elements (e) constituting the article model 2 and coordinate values of node points thereof are entered in the storage device of the computer 1. This operation is performed by an operator through the input devices.

The golf ball model 2a is made up of three-dimensional hexahedral elements, most of the node points of which are coupled with one another. Thus, the spherical golf ball is modeled as a pseudo-spherical polyhedron. Incidentally, it is also possible that the golf ball model 2a is made with other types of elements than the above-mentioned hexahedral elements.

The golf ball as the analysis object is made of viscoelastic materials only, and composed of a spherical core and a thin cover surrounding the core. The core and cover are made of different viscoelastic materials suitable for the respective functions.

<Step S2>

secondly, for each of the elements (e) of the article model 2 (golf ball model 2a), a value of a viscoelastic property of the viscoelastic material which the element represents is defined.

The viscoelastic material has a strain amount dependency and shows different stress-strain relation and hysteresis loss depending on the strain amount (maximum strain amount).

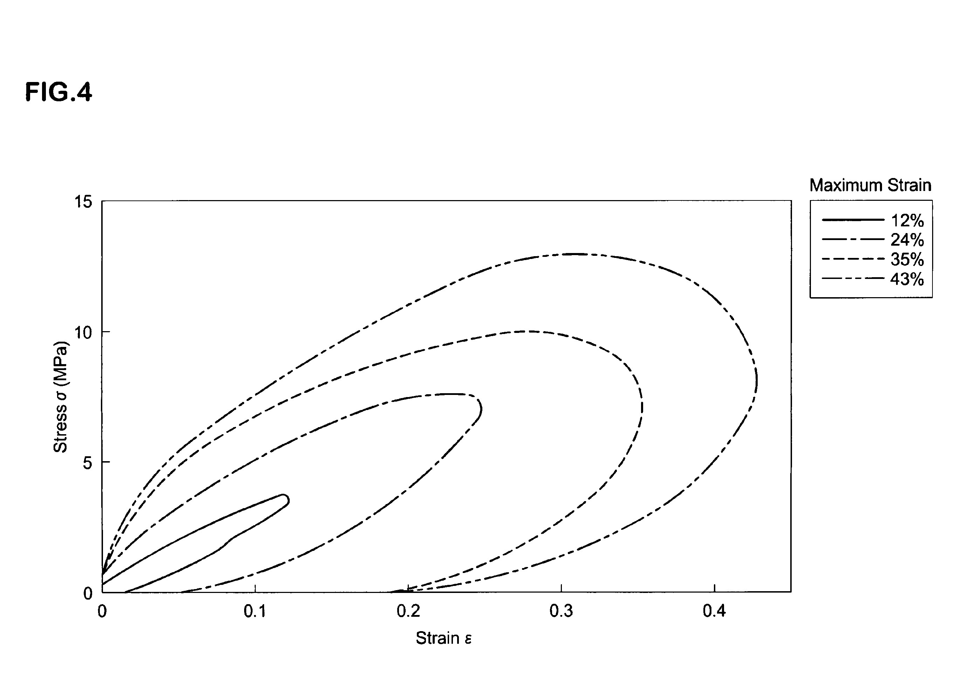

Fig.4 is a graph showing a viscoelastic property (stress-strain relation) of a viscoelastic material whose principal component is polyurethane obtained by a split Hopkinson bar method at an ambient temperature of 23 deg.c, and a relative humidity of 50%.

In Fig.4, different types of lines show stress-strain curves obtained by changing the maximum of the strain amount. Each of the stress-strain curves loops, and the area enclosed in the loop corresponds to the hysteresis loss.

As for how to define the value of the viscoelastic property (initial value) for each of the elements (e) of the article model 2 (golf ball model 2a), two examples follow.

[First example]

For each of the materials used in the article, a value of the viscoelastic property of the material measured at a certain strain amount is defined.

In the case of the golf ball, for each of the elements of the golf ball model 2a constituting the cover, a value of the viscoelastic property of the viscoelastic material of the cover measured at a certain strain amount x is defined. And for each of the elements of the golf ball model 2a constituting the core, a value of the viscoelastic property of the viscoelastic material of the core measured at the same strain amount x as in the cover is defined.

[Second example]

For each of the elements of the golf ball model 2a, a value of the viscoelastic property corresponding to a strain amount which is expected in the undermentioned deformation simulation is defined.

For example, in the case of a golf ball, the strain amount in each part of the golf ball may be assumed from previously obtained actual test data.

Therefore, if the deformation simulation is for a rebound characteristic simulation in which the golf ball model is hit by a golf club model at a certain hitting speed, a value of the viscoelastic property measured at the expected strain amount is used as the initial value of the viscoelastic property of the golf ball material.

As explained, the values of the viscoelastic property are defined for the elements of the golf ball model 2a (article model 2) corresponding to the core and cover, and entered and stored in the computer 1. Thereby, the article model 2 is defined.

In this relation, it is preferable that the measuring of the viscoelastic material is carried out at a strain rate corresponding to the deformation rate in the deformation simulation, whereby it is possible to include a strain rate dependency in the initial value of the viscoelastic property.

<Step S3>

Thirdly, based on a finite element method, a deformation simulation is made on the article model 2 (golf ball model 2a).

The deformation simulation includes various kinds of simulations.

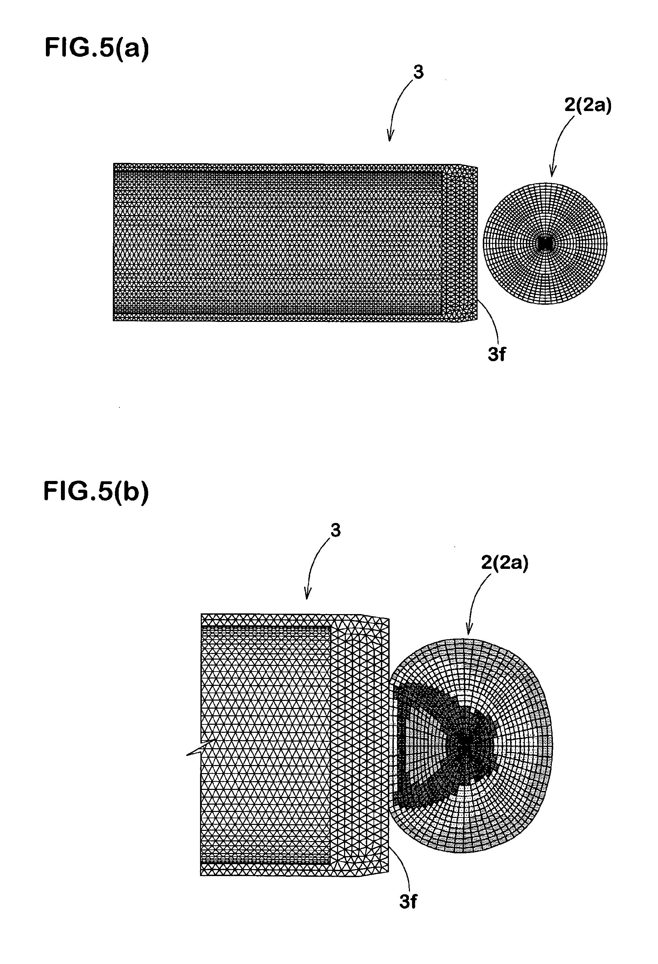

For example, the deformation simulation can include a rebound evaluation simulation in which rebound characteristics of a golf ball are evaluated. Figs.5 (a) and 5(b) show a rebound evaluation simulation in which the golf ball model 2a and a flat hitting surface 3f of a cylindrical impact tool model 3 hit each other under conditions approximate to the actual hitting conditions.

Aside from such dynamic simulations, static simulations (for example, a compression test in which the golf ball model 2a or article model 2 is compressed to a plane by a specified force) are also included in the deformation simulation.

In the deformation simulation, deformed state of the article model 2 is calculated at small time intervals from the beginning of the deformation (beginning of the hit of the golf ball model 2a), and the necessary historical data on the change in the physical value are stored in the computer 1.

In the course of the deformation calculation, in order to duplicate the viscoelastic property of each of the elements, a viscoelasticity model can be employed in the deformation calculation of the element. Maxwell model, Kelvin-voight model and generalized Maxwell model are typical examples of the viscoelasticity model which can be used suitably.

This kind of the deformation simulation can be made, for example, by using a general-purpose explicit solver software "LS-DYNA" of Livermore software Technology Corp. on the computer.

Fig.5(b) shows a visualization of the deformed state at a certain moment during the impact of the golf ball model 2a and impact tool model 3.

As shown in this figure, in each of the core and cover of the golf ball model 2a, the strain amount becomes larger on the impact tool model 3 side, but becomes smaller on the opposite side. In actuality, the strain amount is broken up into several levels to indicate in different colors, therefore, the level of the strain amount is readily recognizable.

As readily understandable from the above explanation, if the fixed value of the viscoelastic property is uniformly defined for the elements of the cover and the fixed value of the viscoelastic property is uniformly defined for the elements of the core, then it is impossible to make highly accurate simulation due to the strain amount dependency.

<Step S4>

All of the elements (e) constituting the article model 2 (golf ball model 2a) are classified into a plurality of groups based on their strain amount. This process is automatically carried out by the computer 1.

with respect to each of the elements (e), the strain amount during one deformation cycle from the beginning of the deformation to the dissipation of the deformation is determined from the above-mentioned deformation simulation.

As to the strain amount, the maximum value of the strain amount of each element (e) during one deformation cycle is used in this embodiment.

However, according to the needs of the deformation simulation to be made, an average value of the strain amount over one deformation cycle or a value of the strain amount at a certain moment from the beginning of the deformation can be used instead of the maximum value of the strain amount.

As to the direction of the strain, tensile strain, compressive strain, and/or shear strain can be used according to the needs of the deformation simulation to be made.

In this embodiment, according to the strain amount $\varepsilon$, the elements are classified into five groups G1-G5 as follows.

group G1: 0% $\leq \varepsilon$ < 10%
group G2: 10% $\leq \varepsilon$ < 20%
group G3: 20% $\leq \varepsilon$ < 30%
group G4: 30% $\leq \varepsilon$ < 40%
group G5: 40% $\leq \varepsilon$ < 50%

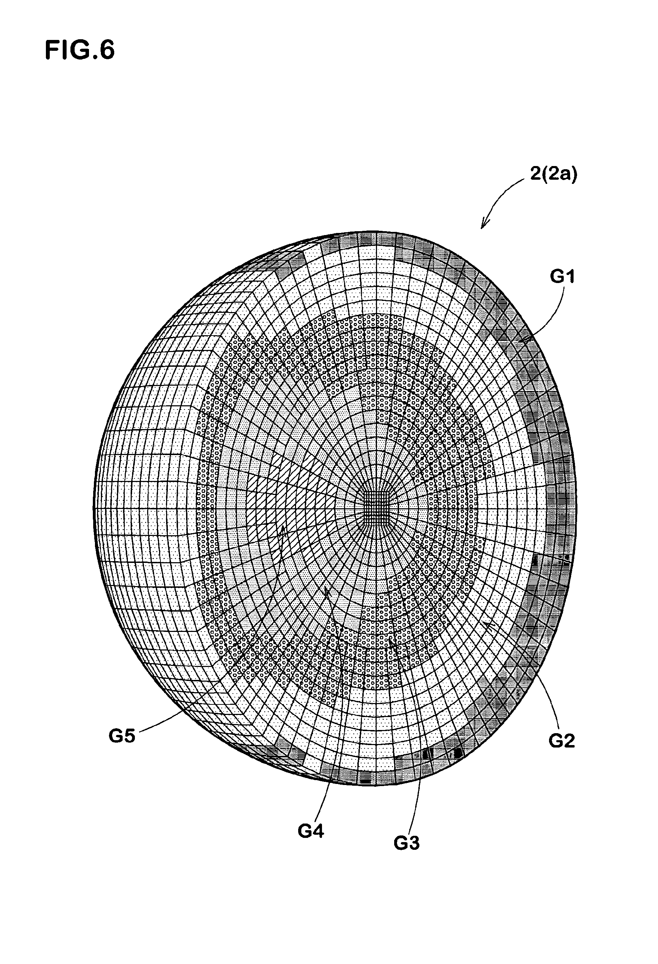

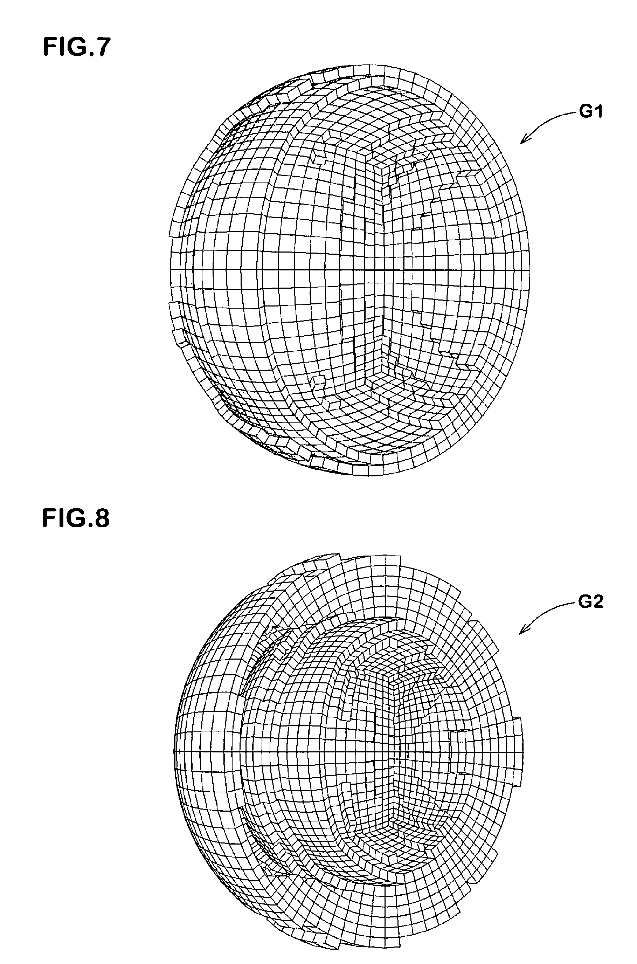

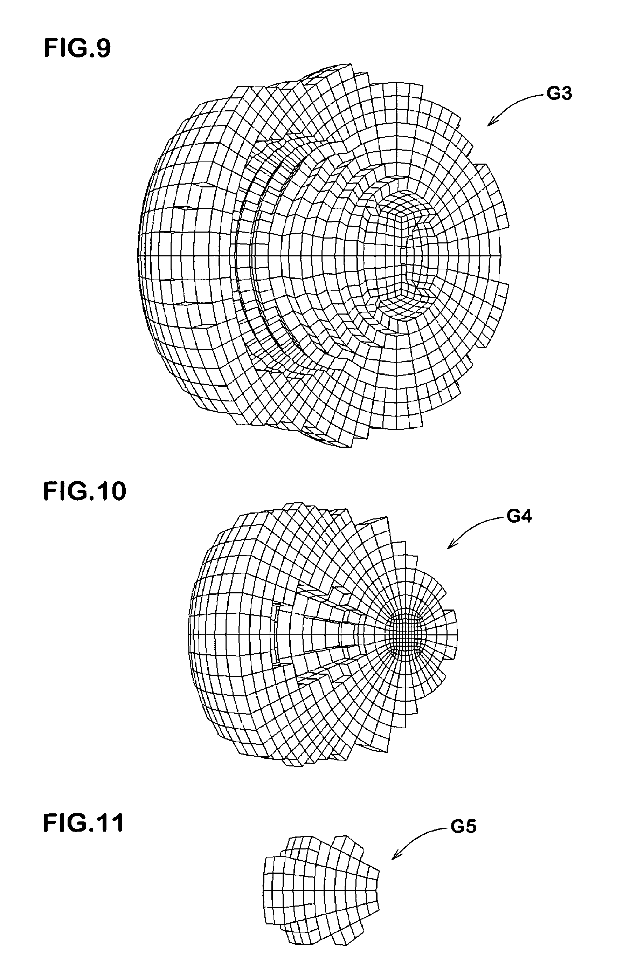

Fig.6 shows these five groups G1-G5 which are differentiated from one another by using different colors in actuality. In Fig.6, the left-hand side of the golf ball model 2a is hit by the impact tool model 3. The groups G1-G5 are separately shown in Figs.7-11, respectively.

<Step S5>

The difference between the value of the viscoelastic property already defined for each of the elements in Step 2 and the value of the viscoelastic property at the strain amount determined from the deformation simulation in Step 3 is evaluated, and

if needed, the already defined value of the viscoelastic property is renewed by the newly determined appropriate value of the viscoelastic property including the strain amount dependency, and redefined for the same element.

With respect to each of the viscoelastic materials, the values of the viscoelastic property are measured in advance changing the strain amount, and data on the relations between the strain amount and the viscoelastic property are stored in the computer beforehand. Therefore, the appropriate value of the viscoelastic property can be retrieved based on the strain amount obtained from the deformation simulation in Step 3.

The obtained strain amount of the elements in each of the groups G1-G5 has a certain range.

Therefore, in this embodiment, for all of the elements in each of the groups G1-G5, an identical strain amount is used to retrieve the appropriate value(s) of the viscoelastic property.

As to the identical strain amount, preferably the intermediate value in the strain amount range is used. For example, in the case of the group G1, the strain amount ranges from 0 to 10%, therefore, the intermediate value of 5% is preferably used. Namely,

5% is used in group G1,
5% is used in group G2,
25% is used in group G3,
35% is used in group G4,
45% is used in group G5.

It is not necessarily the case that all of the elements in one group represent an identical viscoelastic material. For example, the group G2 includes the elements of the core and the elements of the cover are included.

Accordingly, in the group G2, for the elements of the core, the value of the viscoelastic property of the core material measured at 15% strain amount is redefined, and for the elements of the cover, the value of the viscoelastic property of the cover material measured at 15% strain amount is redefined. Namely, in group G1, value(s) at 5% strain amount is(are) redefined, in group G2, value(s) at 15% strain amount is(are) redefined, in group G3, value(s) at 25% strain amount is(are) redefined, in group G4, value(s) at 35% strain amount is(are) redefined, in group G5, value(s) at 45% strain amount is(are) redefined.

<Step S6>

In this embodiment, on the article model 2 (golf ball model 2a) of which values of the viscoelastic property have been redefined, the above-mentioned deformation simulation is again carried out under the same simulation conditions as those in the previous deformation simulation.

<Step S7>

In order to obtain highly-accurate final calculation results, a convergence calculation process is made by repeating the step S5 and step S6 at least once or until the difference between a physical quantity obtained from the present deformation simulation and that obtained from the most recent deformation simulation becomes within the predetermined acceptable range.

In another way, it is possible to end the convergence calculation when the difference between the distribution of the strain amount obtained from the present deformation simulation and the distribution of the strain amount obtained from the most recent deformation simulation becomes within the predetermined acceptable range.

The physical quantity may be all kinds of physical quantity necessary for evaluating the performance and/or characteristic are obtained, for example, the strain amount of each element, compressibility, coefficient of restitution and the like.

For example, in the case that the deformation simulation is for a rebound evaluation simulation in which the coefficient of restitution is evaluated, it is preferable that the steps S5 and S6 are repeated until the difference between the coefficient of restitution obtained from the most recent rebound evaluation simulation and the coefficient of restitution obtained from the rebound evaluation simulation after the values of the viscoelastic property has been redefined becomes not more than 10%, more preferably not more than 5%, still more preferably not more than 3%.

<Step S8>

From the last deformation simulation, the physical quantities are obtained, and the obtained quantities are outputted in an appropriate form, for example, as visual information such as printed or displayed graph, image, characters, etc., and/or as electrical data or signals to be used in the subsequent data processing.

As explained, in the second or subsequent deformation simulation, since the calculation results include the influence of the strain amount dependency of the viscoelastic property (in this embodiment, influence of the strain rate dependency is also included), in comparison with the deformation simulation carried out in the previous step S3, more accurate calculation results can be obtained.

In order to introduce the strain amount dependency into the values of the viscoelastic property of each of the elements with precision, it is desirable to increase the number of the groups. In this light, the number of the groups is preferably not less than 3, more preferably not less than 5, still more preferably not less than 10. However, if the groups are too many, the computational time and cost increases, therefore, it is preferable that the number of the groups is not more than 20.

[Comparison Tests]

In order to confirm the effects of the simulation method according to the present invention, with respect to the following four kinds of two-piece golf balls A-D, ball-hitting simulation in order to evaluate the amount of spin and rebound velocity was carried out, and further, rebound evaluation simulation in order to evaluate the coefficient of restitution of the core was carried out.

| Golf ball | A | B | C | D |
|---|---|---|---|---|
| Outer diameter (mm) | 42.7 | 42.7 | 42.7 | 42.7 |
| Ball weight (g) | 45.6 | 45.6 | 45.9 | 45.9 |
| Cover<br>  Material<br>  Thickness (mm) | polyurethane<br>2.0 | polyurethane<br>2.0 | polyurethane<br>1.4 | polyurethane<br>1.4 |

(continued)

| Golf ball | A | B | C | D |
|---|---|---|---|---|
| Core | | | | |
| Outer diameter (mm) | 38.7 | 38.7 | 39.9 | 39.9 |
| Weight (g) | 34.6 | 34.6 | 38.3 | 38.3 |
| Material | | | | |
| Compositions | | | | |
| BR730 | 100 | 100 | 100 | 100 |
| Sanceler SR | 29 | 38 | 29 | 38 |
| White seal | 5 | 5 | 5 | 5 |
| Barium sulfate BD | 10 | 6.2 | 10 | 6.2 |
| DPDS | 0.5 | 0.5 | 0.5 | 0.5 |
| DCP | 0.8 | 0.8 | 0.8 | 0.8 |
| JIS-C hardness distribution | | | | |
| @ 0 (mm) | 59 | 66 | 58 | 66 |
| @ 5 (mm) | 67 | 77 | 67 | 76 |
| @ 10 (mm) | 68 | 77 | 68 | 77 |
| @ 15 (mm) | 73 | 80 | 72 | 79 |

The golf balls A-D each had such a hardness distribution such that the hardness is smoothly increased from the center of the core towards the outside. The values of JIS-C hardness measured at the distances of 0, 5, 10 and 15 mm from the center of the core are shown in the table.

<First simulation>

Golf ball models A-D of the golf balls A-D were defined according to their structures.
Each of the core model and the cover model was a generalized Maxwell model.
For each of the elements of the core model, the value of the viscoelastic property(initial value) of the viscoelastic material measured at 15% strain amount was defined.
For each of the elements of the cover model, the value of the viscoelastic property(initial value) of the viscoelastic material measured at 5% strain amount was defined.
The values of the viscoelastic property was determined through a relaxation test using a slab of the viscoelastic material.

[Rebound evaluation simulation}

Actual rebound test was carried out according to the initial velocity test procedure of R&A Rules Limited, wherein the core at rest was hit by an aluminum cylindrical body of 198 grams at a velocity (V1) of 40 m/s, and the velocity (V1') of the cylindrical body and the velocity (V2') of the golf ball after the hit were measured. From the measured velocities, the coefficient of restitution of the core was determined through the calculation of the following expression:

$$\text{Coefficient of restitution (COR)} = (V2' - V1')/V1.$$

Then, the rebound evaluation simulation was carried out under the same testing conditions as above.
In the rebound evaluation simulation, as shown in Fig.3 to Fig.6, used as the core model was one half (hemisphere) of the part corresponding to the core of the golf ball model, wherein the core model was made with hexahedral solid elements the number of which was 15200, and
the impact tool model 3 was made with tetrahedral solid elements the number of which was 39119.

[Ball-hitting simulation]

Actual rebound test was carried out as follows.

Using a golf club (driver "XXIO 4" manufactured by SRI Sports Limited, shaft flex R, loft angle 11 degrees) mounted on a swing robot, the golf balls were hit at head speed of 21 m/s, 40 m/s and 50 m/s, and the amount of spin and rebound velocity of the golf ball immediately after the impact were measured. Further, data on the motion of the club head immediately before the impact (e.g. blow angle, loft angle and shaft inclination angle) and the ball hitting position in the club face were measured to utilize these in the simulation.

Then, the ball-hitting simulation was carried out under the same testing conditions as above.

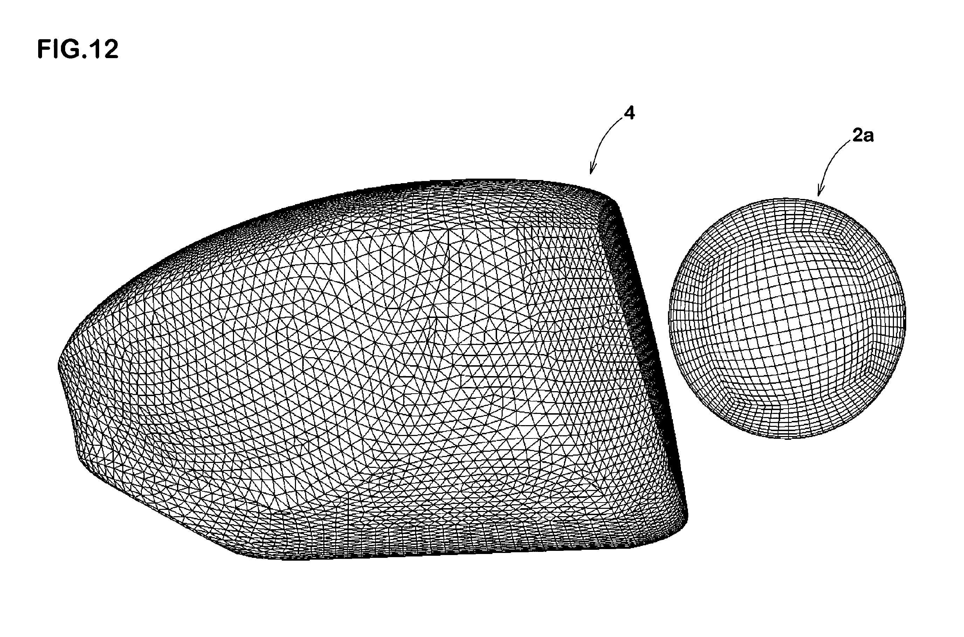

In the ball-hitting simulation, as shown in Fig.12, the golf ball model 2a was made with hexahedral solid elements the number of which was 30400, and a club head model 4 of a driver was made with tetrahedral solid elements the number of which was 84927.

The coefficient of friction between the club head model 4 and the golf ball model 2a was set to 0.15.

In the ball-hitting simulation, the club head model 4 was moved according to the three-dimensional motion measured in the above-mentioned actual rebound test immediately before the impact.

The solver used was LS-DYNA ver.971R4.2.

The computer used was Altix XE340 (CPU: two parallel Intel(R) xeon(R) processors, Memory: 16 GB) manufactured by SGI Japan Ltd.

The calculation time of the rebound evaluation simulation was about 20 minutes.

The calculation time of the ball-hitting simulation was about 100 minutes.

<Second simulation>

The maximum value εm of the strain amount of each of the elements was pulled up from the time history of the strain amount of each of the elements calculated in the first simulation.

And according to the maximum value εm of the strain amount, the elements were classified into groups and the values of the viscoelastic property were redefined as follows.

<Core>   group (0%≤εm<7.5%):     value at 3% strain amount
          group (7.5%≤εm):        value at 15% strain amount
<Cover>  group (0%≤εm<2%):       value at 1% strain amount
          group (2%≤εm<4%):       value at 3% strain amount
          group (4%≤εm<6%):       value at 5% strain amount
          group (6%≤εm<8%):       value at 7% strain amount
          group (8%≤εm<10%):      value at 9% strain amount

Then, under the same test conditions as in the first simulation, the second rebound evaluation simulation and the second ball-hitting simulation were carried out.

In Tables 3-9, together with the results of the actual tests, the results in the first simulations are shown as "Reference" where the strain amount dependency was not taken into consideration, and the results in the second simulations are shown as "Embodiment" where the strain amount dependency was taken into consideration.

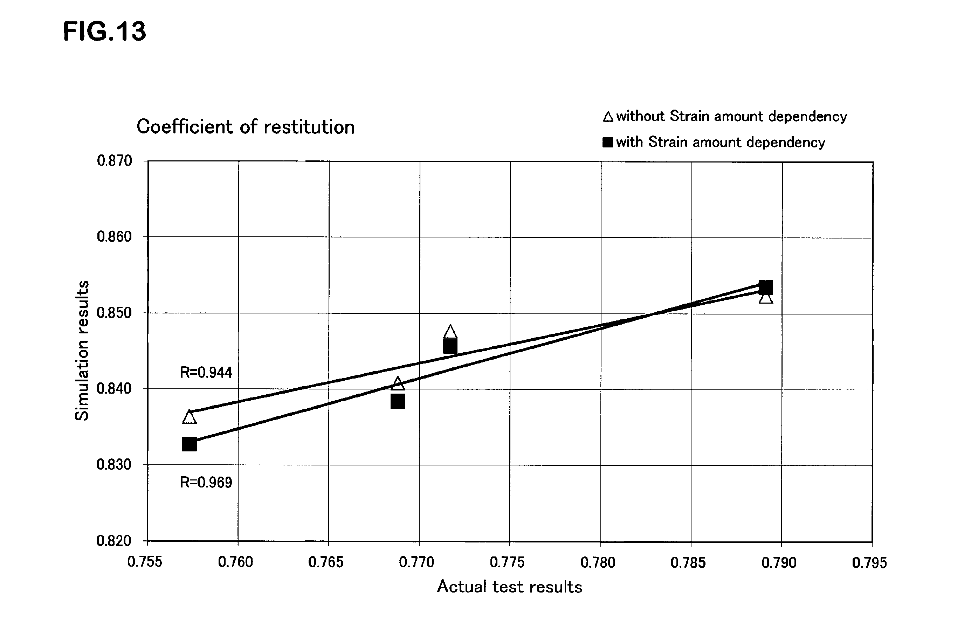

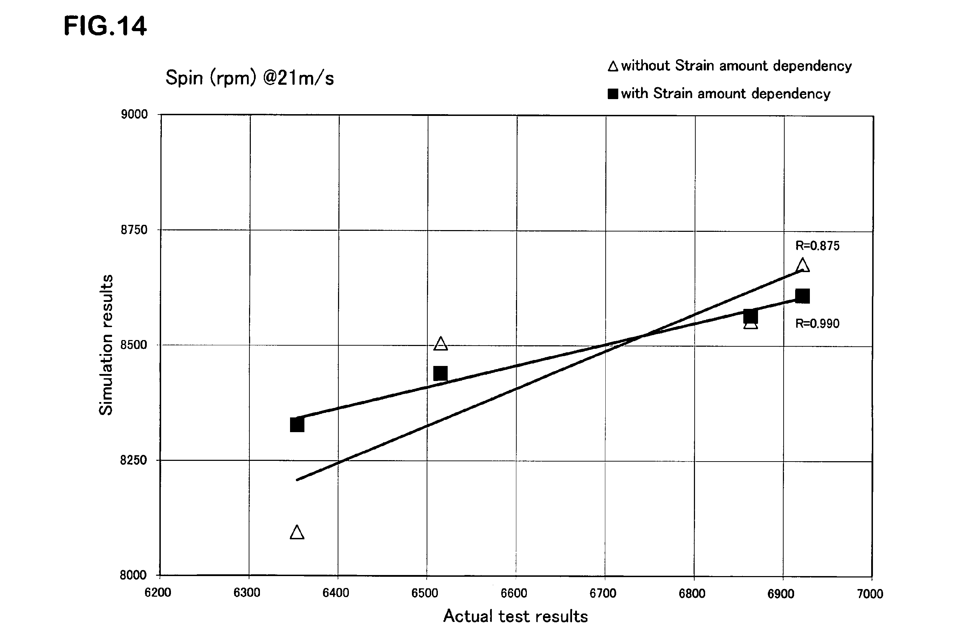

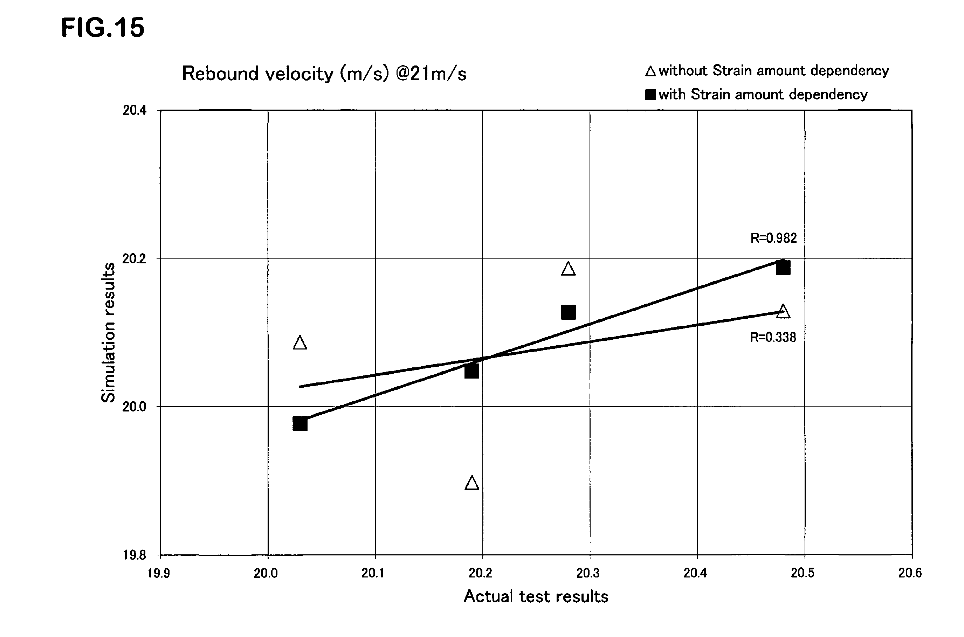

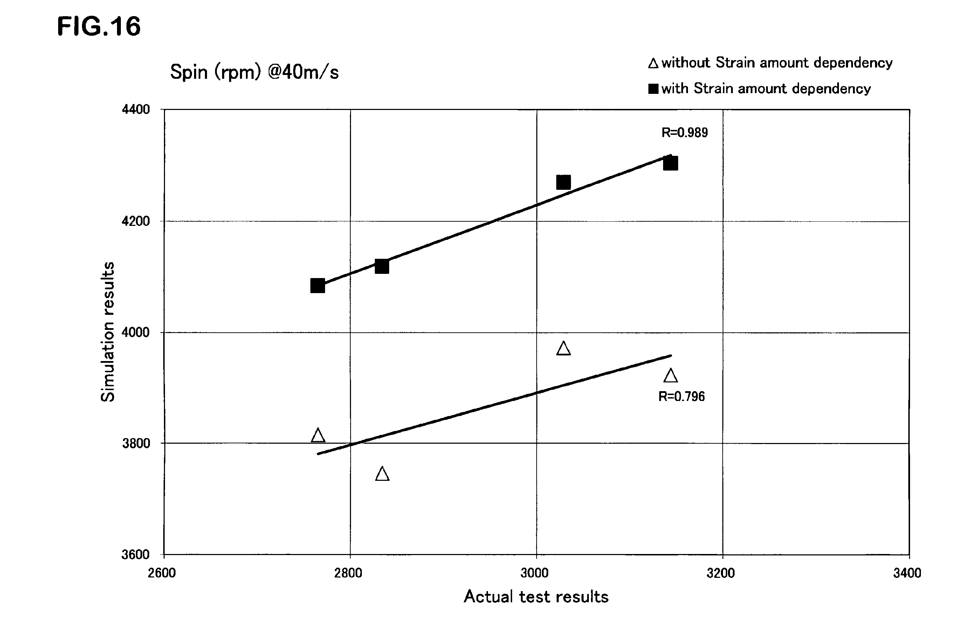

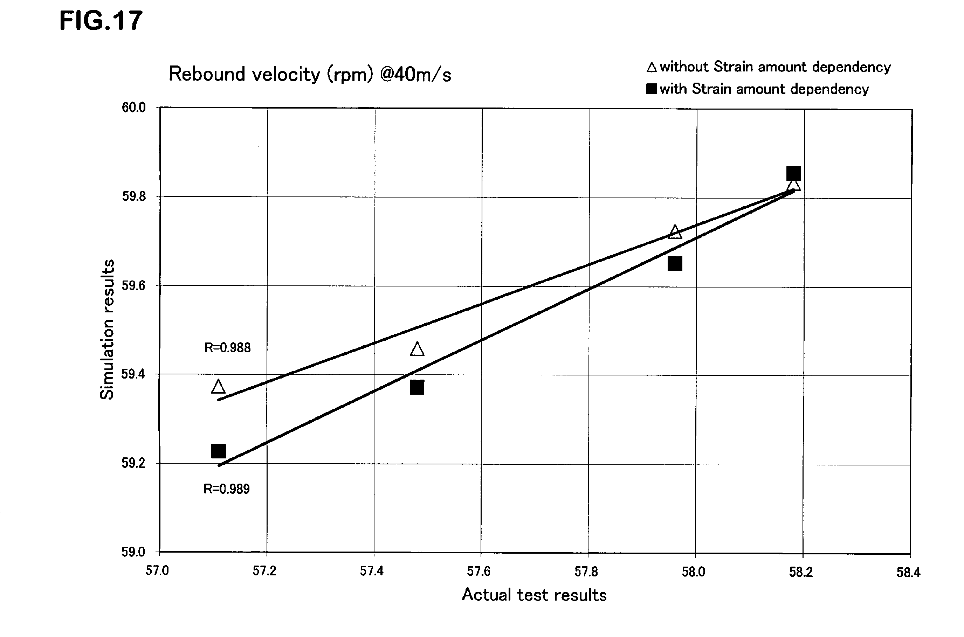

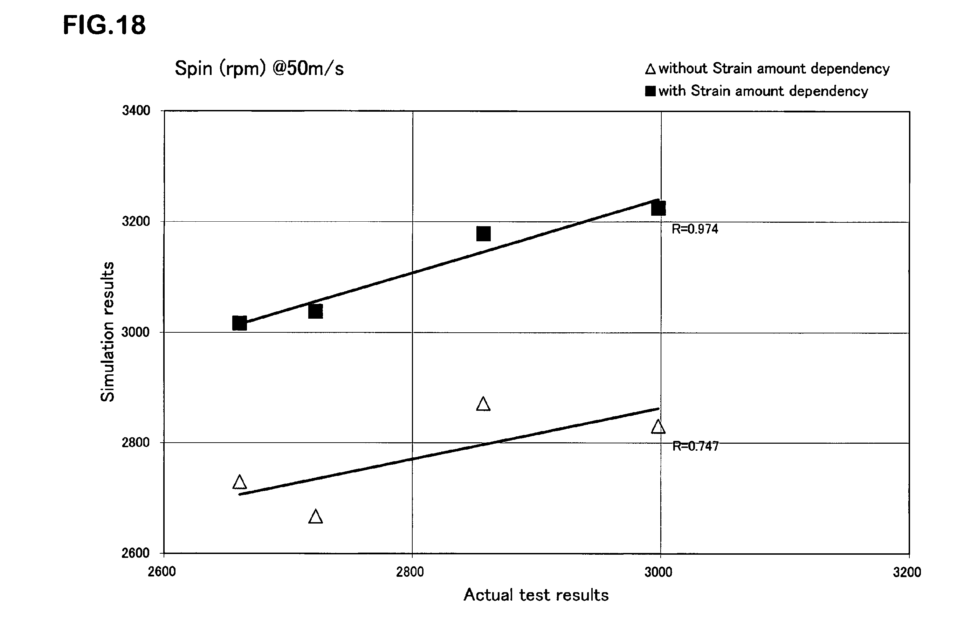

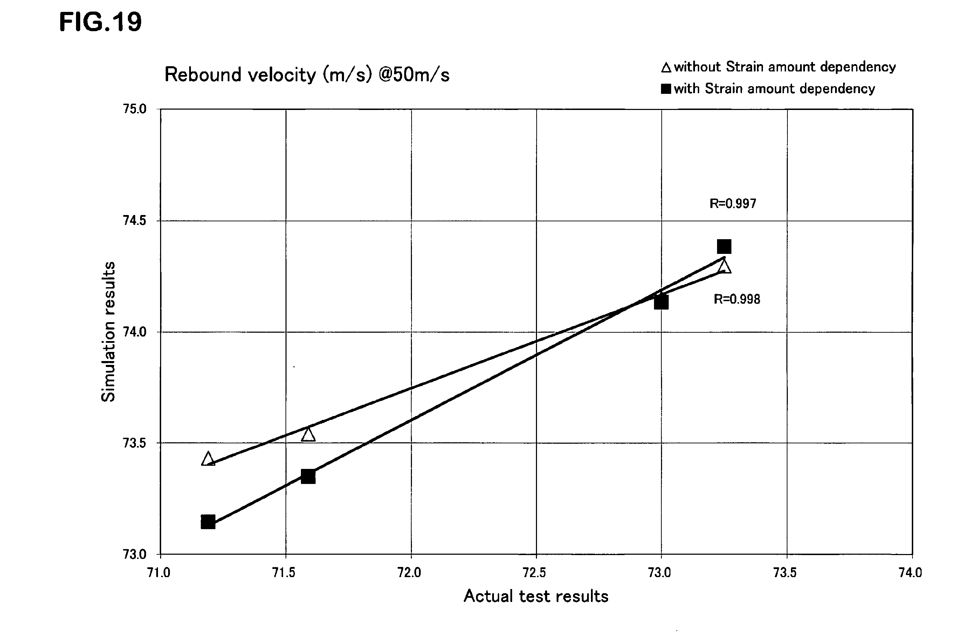

Further, in Fig.13 to Fig.19, graphs of coefficient of correlation between the actual test results and the first simulation results, and graphs of coefficient of correlation between the actual test results the second simulation results are shown.

Table 3 - coefficient of restitution

| Ball | A | B | C | D | Correlation coefficient |
|---|---|---|---|---|---|
| Actual test | 0.757 | 0.772 | 0.769 | 0.789 | - |
| First simulation | 0.836 | 0.848 | 0.841 | 0.852 | 0.944 |
| Second simulation | 0.833 | 0.846 | 0.838 | 0.853 | 0.969 |

Table 4 - Spin(rpm)@21m/s

| Ball | A | B | C | D | Correlation coefficient |
|---|---|---|---|---|---|
| Actual test | 6354 | 6863 | 6515 | 6921 | - |
| First simulation | 8095 | 8554 | 8505 | 8679 | 0.875 |

8

(continued)

| Ball | A | B | C | D | Correlation coefficient |
|------|---|---|---|---|--------------------------|
| Second simulation | 8327 | 8565 | 8440 | 8610 | 0.990 |

Table 5 - Rebound speed (m/s)@21m/s

| Ball | A | B | C | D | Correlation coefficient |
|------|---|---|---|---|--------------------------|
| Actual test | 20.19 | 20.03 | 20.48 | 20.28 | - |
| First simulation | 19.90 | 20.09 | 20.13 | 20.19 | 0.338 |
| Second simulation | 20.05 | 19.98 | 20.19 | 20.13 | 0.982 |

Table 6 - Spin(rpm)@40m/s

| Ball | A | B | C | D | Correlation coefficient |
|------|---|---|---|---|--------------------------|
| Actual test | 2834 | 3144 | 2765 | 3029 | - |
| First simulation | 3746 | 3922 | 3815 | 3972 | 0.796 |
| Second simulation | 4119 | 4304 | 4084 | 4269 | 0.989 |

Table 7 - Rebound speed (rpm)@40m/s

| Ball | A | B | C | D | Correlation coefficient |
|------|---|---|---|---|--------------------------|
| Actual test | 57.11 | 57.96 | 57.48 | 58.18 | - |
| First simulation | 59.37 | 59.72 | 59.46 | 59.83 | 0.988 |
| Second simulation | 59.23 | 59.65 | 59.37 | 59.86 | 0.989 |

Table 8 - Spin(rpm)@50m/s

| Ball | A | B | C | D | Correlation coeffcient |
|------|---|---|---|---|-------------------------|
| Actual test | 2722 | 2998 | 2661 | 2857 | - |
| First simulation | 2667 | 2831 | 2729 | 2871 | 0.747 |
| Second simulation | 3038 | 3225 | 3016 | 3179 | 0.974 |

Table 9 - Rebound speed (m/s)@50m/s

| Ball | A | B | C | D | Correlation coefficient |
|------|---|---|---|---|--------------------------|
| Actual test | 71.19 | 73.00 | 71.59 | 73.25 | - |
| First simulation | 73.43 | 74.15 | 73.54 | 74.30 | 0.998 |
| Second simulation | 73.15 | 74.13 | 73.35 | 74.39 | 0.997 |

From the test results it was confirmed that, in both of the rebound evaluation simulation and ball-hitting simulation, the test results of the second simulation corresponding to a method according to the present invention, show higher correlation coefficients than those in the first simulation corresponding to a conventional simulation method. Therefore, according to the present invention, it is possible to quantitatively predict performances and/or properties of the article with accuracy which is very important for the simulations for the purpose of development of articles.

**Claims**

1. A method for computerized simulation of an article made of a viscoelastic material comprises:

    a step of defining an article model (2, 2a) of the article made with a finite number of elements;
    a step of defining a value of a viscoelastic property for each of the elements (e) of the article model (2, 2a);
    a step of making a deformation simulation of the article model (2, 2a);
    the following three steps carried out at least once:

        a step of obtaining a strain amount of each of the elements (e) from the deformation simulation,
        a step of renewing the values of the viscoelastic property according to the obtained strain amounts so as to redefine the article model (2, 2a), and
        a step of again making the deformation simulation on the redefined article model (2, 2a); and

    a step of outputting a simulation result of the deformation simulation,
    wherein in the step of renewing the values of the viscoelastic property, all of the elements (e) of the article model (2, 2a) are classified into at least two groups according to the strain amount, and
    in each of the groups, the elements (e) therein are provided with value(s) of the viscoelastic property at an identical strain amount.

2. The method according to claim 1, wherein
    discrete data on values of the viscoelastic property are previously prepared by measuring the viscoelastic material at different strain amounts, and
    in the step of renewing the values of the viscoelastic property, the previously defined value of the viscoelastic property is replaced by one of the discrete data of which strain amount is nearest to the obtained strain amount.

3. The method according to any one of claims 1-2, wherein
    said three steps carried out at least once are repeated until the difference between a physical quantity obtained from the present deformation simulation and a physical quantity obtained from the most recent deformation simulation becomes within a predetermined acceptable range.

4. The method according to any one of claims 1-3, wherein
    the strain amount is a maximum strain amount during one deformation cycle.

5. The method according to any one of claims 1-4, wherein
    in the step of defining a value of a viscoelastic property for each of the elements of the article model, said value of the viscoelastic property is that obtained from a previous measurement of the viscoelastic material at a strain amount expected in the deformation simulation.

**Patentansprüche**

1. Verfahren zur rechnergestützten Simulation eines aus einem viskoelastischen Material hergestellten Gegenstandes, umfassend:

    einen Schritt eines Definierens eines Gegenstandmodells (2, 2a) des hergestellten Gegenstandes mit einer finiten Zahl von Elementen;
    einen Schritt eines Definierens eines Wertes einer Viskoelastizitätseigenschaft für jedes der Elemente (e) des Gegenstandmodells (2, 2a);
    einen Schritt eines Durchführens einer Verformungssimulation des Gegenstandmodells (2, 2a);
    wobei die folgenden drei Schritte zumindest einmal ausgeführt werden:

        ein Schritt eines Beschaffens eines Dehnungsbetrages von jedem der Elemente (e) aus der Verformungssimulation,
        ein Schritt eines Erneuerns des Wertes der Viskoelastizitätseigenschaft gemäß den erhaltenen Dehnungsbeträgen, um das Gegenstandmodell (2, 2a) neu zu definieren, und
        ein Schritt eines erneuten Durchführens der Verformungssimulation des neu definierten Gegenstandmodells (2, 2a); und

einen Schritt eines Ausgebens eines Simulationsergebnisses der Verformungssimulation,
wobei bei dem Schritt des Erneuerns der Werte der Viskoelastizitätseigenschaft alle Elemente (e) des Gegenstandmodells (2, 2a) in zumindest zwei Gruppen gemäß dem Dehnungsbetrag klassifiziert werden, und in jeder der Gruppen die Elemente (e) darin mit einem Wert/Werten der Viskoelastizitätseigenschaft bei einem identischen Dehnungsbetrag versehen werden.

2. Verfahren nach Anspruch 1, wobei
diskrete Daten von Werten der Viskoelastizitätseigenschaft im Voraus vorbereitet werden, indem das viskoelastische Material bei unterschiedlichen Dehnungsbeträgen gemessen wird, und
bei dem Schritt des Erneuerns der Werte der Viskoelastizitätseigenschaft der im Voraus definierte Wert der Viskoelastizitätseigenschaft durch ein Datenelement der diskreten Daten ersetzt wird, dessen Dehnungsbetrag am Nächsten bei dem erhaltenen Dehnungsbetrag liegt.

3. Verfahren nach einem der Ansprüche 1-2, wobei die drei Schritte, die zumindest einmal ausgeführt werden, wiederholt werden, bis die Differenz zwischen einer physikalischen Größe, die aus der gegenwärtigen Verformungssimulation erhalten wird, und einer physikalischen Größe, die aus der jüngsten Verformungssimulation erhalten wird, derart wird, dass sie in einem vorbestimmten annehmbaren Bereich liegt.

4. Verfahren nach einem der Ansprüche 1-3, wobei der Dehnungsbetrag ein maximaler Dehnungsbetrag während eines Verformungszyklus ist.

5. Verfahren nach einem der Ansprüche 1-4, wobei bei dem Schritt des Definierens eines Wertes einer Viskoelastizitätseigenschaft für jedes der Elemente des Gegenstandmodells der Wert der Viskoelastizitätseigenschaft derjenige ist, der aus einer vorherigen Messung der Viskoelastizitätseigenschaft bei einem bei der Verformungssimulation erwarteten Dehnungsbetrag erhalten wird.

**Revendications**

1. Procédé pour simulation à l'ordinateur d'un article réalisé en un matériau viscoélastique, comprenant :

une étape consistant à définir un modèle d'article (2, 2a) de l'article réalisé avec un nombre fini d'éléments ;
une étape consistant à définir une valeur d'une propriété viscoélastique pour chacun des éléments (e) du modèle d'article (2, 2a) ;
une étape consistant à effectuer une simulation de déformation du modèle d'article (2, 2a) ;
les trois étapes suivantes, effectuées au moins une fois :

une étape consistant à obtenir une valeur de contraintes de chacun des éléments (e) à partir de la simulation de déformation,
une étape consistant à renouveler les valeurs de la propriété viscoélastique en accord avec les valeurs de contraintes obtenues,
de manière à redéfinir le modèle d'article (2, 2a), et
une étape consistant à effectuer à nouveau la simulation de
déformation sur le modèle d'article redéfini (2, 2a) ; et

une étape consistant à délivrer un résultat de simulation de la simulation de déformation,
dans lequel, dans l'étape de renouvellement des valeurs de la propriété viscoélastique, tous les éléments (e) du modèle d'article (2, 2a) sont classifiés en au moins deux groupes en accord avec la valeur de contrainte, et
dans chacun des groupes, les éléments (e) dans celui-ci sont dotés de valeur(s) de la propriété viscoélastique à une valeur de contrainte identique.

2. Procédé selon la revendication 1, dans lequel
des données discrètes sur des valeurs de la propriété viscoélastique sont auparavant préparées en mesurant le matériau viscoélastique à différentes valeurs de contraintes, et
dans l'étape de renouvellement des valeurs de la propriété viscoélastique, la valeur auparavant définie de la propriété viscoélastique est remplacée par l'une des données discrètes dont la valeur de contrainte est la plus proche de la valeur de contrainte obtenue.

**3.** Procédé selon l'une quelconque des revendications 1 et 2, dans lequel
lesdites trois étapes effectuées au moins une fois sont répétées jusqu'à ce que la différence entre une quantité physique obtenue de la présente simulation de déformation et une quantité physique obtenue de la simulation de déformation la plus récente tombe dans une plage acceptable prédéterminée.

**4.** Procédé selon l'une quelconque des revendications 1 à 3, dans lequel la valeur de contrainte est une valeur de contrainte maximum pendant un cycle de déformation.

**5.** Procédé selon l'une quelconque des revendications 1 à 4, dans lequel, dans l'étape consistant à définir une valeur d'une propriété viscoélastique pour chacun des éléments du modèle d'article, ladite valeur de la propriété viscoélastique est celle qui est obtenue d'une mesure précédente du matériau viscoélastique à une valeur de contrainte attendue dans la simulation de déformation.

**FIG.1**

# FIG.2

```
          ┌──────────────┐
          │    Start     │
          └──────┬───────┘
                 │
   ┌─────────────────────────────┐        S1
   │      Define Article model   │
   └─────────────┬───────────────┘
                 │
   ┌─────────────────────────────┐        S2
   │  Define Initial value of    │
   │  viscoelastic property for  │
   │  each element of            │
   │  Article model              │
   └─────────────┬───────────────┘
                 │
   ┌─────────────────────────────┐        S3
   │  Make Deformation simulation│
   └─────────────┬───────────────┘
                 │
   ┌─────────────────────────────┐        S4
   │  Classify Elements into     │
   │  Groups based on Strain     │
   │  amount obtained            │
   └─────────────┬───────────────┘
                 │
   ┌─────────────────────────────┐        S5
   │  Determine Viscoelastic     │
   │  property's values by Strain│
   │  amount obtained and        │
   │  Redefine them for Elements │
   │  in each group              │
   └─────────────┬───────────────┘
                 │
   ┌─────────────────────────────┐        S6
   │  Make Deformation simulation│
   └─────────────┬───────────────┘
                 │
            ╱ Is        ╲                  S7
           ╱ Difference  ╲
    No    ╱ of Simulation ╲
   ←─────╱  result from    ╲
         ╲  Previous       ╱
          ╲ simulation in  ╱
           ╲ Acceptable   ╱
            ╲ range ?    ╱
                 │ Yes
   ┌─────────────────────────────┐        S8
   │  Obtain Physical quantity   │
   │  necessary for evaluation   │
   │  from Last simulation       │
   └─────────────┬───────────────┘
                 │
          ┌──────────────┐
          │     End      │
          └──────────────┘
```

## FIG.3

# FIG.4

EP 2 397 956 B1

## FIG.5(a)

## FIG.5(b)

**FIG.6**

FIG.7

G1

FIG.8

G2

**FIG.9**

G3

**FIG.10**

G4

**FIG.11**

G5

FIG.12

**FIG.13**

Coefficient of restitution

△ without Strain amount dependency
■ with Strain amount dependency

R=0.944

R=0.969

Simulation results

Actual test results

FIG.14

FIG.15

# FIG.16

Spin (rpm) @40m/s

△ without Strain amount dependency
■ with Strain amount dependency

R=0.989

R=0.796

Simulation results

Actual test results

EP 2 397 956 B1

FIG.17

Rebound velocity (rpm) @40m/s

△ without Strain amount dependency
■ with Strain amount dependency

Simulation results

Actual test results

R=0.988
R=0.989

58.4  58.2  58.0  57.8  57.6  57.4  57.2  57.0

60.0  59.8  59.6  59.4  59.2  59.0

26

FIG.18

Spin (rpm) @50m/s

△ without Strain amount dependency
■ with Strain amount dependency

R=0.974

R=0.747

Actual test results

Simulation results

3400
3200
3000
2800
2600

2600   2800   3000   3200

# FIG.19

Rebound velocity (m/s) @50m/s

△ without Strain amount dependency
■ with Strain amount dependency

R=0.997

R=0.998

Simulation results

Actual test results

EP 2 397 956 B1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7130748 B2

**Non-patent literature cited in the description**

- **K. TANAKA et al.** Construction of the Finite-Element Models of Golf Balls and Simulations of Their Collisions. *Proceedings of the Institution of Mechanical Engineers, Part L: Journal of Materials Design and Applications,* 01 June 2006, vol. 220 (1), 13-22